# DEMANDE DE BREVET EUROPEEN

(11) **EP 3 650 877 A1**
(43) Date de publication de la demande: **13.05.2020**
(21) Numéro de dépôt: 19207255.1
(22) Date de dépôt: 05.11.2019
(51) Int. Cl.: G01R 33/20, G01R 33/24

(54) **MAGNÉTOMÈTRE À EFFET HANLE COMPACT**

(30) Priorité: 08.11.2018 FR 1860319
(71) Demandeur: Commissariat à l'énergie atomique et aux énergies alternatives, 75015 Paris (FR)
(72) Inventeur: BEATO, François, 38054 GRENOBLE cedex 09 (FR); PALACIOS LALOY, Agustin, 38054 GRENOBLE cedex 09 (FR)
(74) Mandataire: Brevalex

(57) **Abrégé**

L'invention porte sur un magnétomètre (10) qui comprend une cellule (1) remplie d'un gaz atomique, une source optique (2 , 3, 9, 11) et un détecteur (6).

La source éclaire la cellule avec une lumière présentant une contribution de pompe (Fp), qui est polarisée linéairement au moins partiellement et sous l'effet de laquelle les atomes du gaz atomique subissent une transition atomique, et une contribution de sonde (Fs), qui est polarisée linéairement et qui subit des variations de polarisation lors de la traversée de la cellule. Les directions de polarisation de la contribution de pompe et de la contribution de sonde sont colinéaires ou orthogonales.

Le détecteur (6) réalise une mesure différentielle de la polarisation circulaire droite et de la polarisation circulaire gauche de la contribution de sonde ayant traversée la cellule.

## Description

### DOMAINE TECHNIQUE

Le domaine de l'invention est celui des magnétomètres à pompage optique, et plus particulièrement celui des magnétomètres à effet Hanle.

### ÉTAT DE LA TECHNIQUE ANTÉRIEURE

Les magnétomètres à pompage optique utilisent des gaz atomiques confinés dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :
1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.
2) Ces états atomiques évoluent sous l'effet du champ magnétique, notamment sous l'effet Zeeman qui correspond à des décalages des niveaux d'énergie en fonction du champ magnétique auquel sont soumis les atomes.
3) Les propriétés optiques du milieu atomique subissent alors des modifications qui dépendent de l'état des atomes. On peut ainsi par une mesure optique, par exemple par une mesure d'absorption optique, remonter au décalage Zeeman subi et en déduire une mesure du champ magnétique dans lequel est plongée la cellule.

Selon les différentes configurations possibles des magnétomètres à pompage optique existants, on distingue une mesure du module, aussi appelée norme, du champ magnétique pour les magnétomètres scalaires, ou une détermination des différentes composantes du champ magnétique à l'emplacement de la cellule pour les magnétomètres vectoriels.

Pour réaliser une mesure vectorielle du champ magnétique avec une bande passante large, il existe deux configurations bien connues : la première dite « à effet Hanle » et la deuxième qui reçoit le nom de « magnétomètre à résonance paramétrique ». Ces configurations sont décrites notamment dans l'article de J. Dupont-Roc, "Détermination par des méthodes optiques des trois composantes d'un champ magnétique très faible," Revue de Physique Appliquée, vol. 5, no. 6, pp. 853-864, 1970. Elles fonctionnent à des valeurs de champ magnétique extérieur très faibles, induisant un décalage Zeeman plus faible que le taux de relaxation des sous-niveaux Zeeman de l'atome, ce qui pour le cas de l'hélium fixe une limite autour de 100 nano Tesla, soit 500 fois moins intense que le champ magnétique terrestre.

Lorsqu'un faible champ magnétique statique transverse est appliqué à la cellule et balayé autour de zéro, les atomes sont soumis à un mouvement de précession et le nombre de photons absorbés, provenant du laser de pompage optique, subit des variations résonantes (effet Hanle). Des résonances analogues, appelées résonances paramétriques, sont observées lorsqu'un champ magnétique radiofréquence est appliqué. Dans ces conditions, le moment magnétique de chaque atome subit des oscillations résonantes aux fréquences multiples de celle du champ radiofréquence. La mesure de l'amplitude de ces oscillations permet de remonter au module de la composante du champ magnétique colinéaire au champ radiofréquence.

Le magnétomètre à effet Hanle a pour inconvénients d'être sensible au bruit basse fréquence du laser de sonde et de reposer, pour une mesure de l'état d'orientation des atomes, sur au moins deux accès optiques orthogonaux à la cellule de mesure ce qui le rend encombrant et complexe à réaliser. Un tel magnétomètre, basé sur un pompage en polarisation circulaire et une mesure polarimétrique par effet Faraday, est par exemple décrit dans J. C. Allred, R. N. Lyman, T. W. Kornack, and M. V. Romalis, "High-Sensitivity Atomic Magnetometer Unaffected by Spin-Exchange Relaxation," Phys. Rev. Lett., vol. 89, no. 13, p. 130801, Sep. 2002.

Le magnétomètre à résonance paramétrique permet de réaliser des mesures de plusieurs composantes d'un champ magnétique avec un seul accès optique à l'aide du ou des champs radiofréquence utilisés pour réaliser la modulation de fréquence des résonances paramétriques. Ce magnétomètre présente cependant les inconvénients suivants :
- Son niveau de signal est dégradé du fait de la présence du ou des champs radiofréquence, les amplitudes des signaux se retrouvant en effet multipliées par des combinaisons de fonctions de Bessel de première espèce inférieures à 1 ;
- Lorsque le magnétomètre est disposé avec d'autres magnétomètres du même type pour former un réseau (par exemple dans le but de réaliser de l'imagerie magnétique), les champs radiofréquence de chaque magnétomètre qui sont créés par des bobines autour de l'élément sensible peuvent affecter les magnétomètres voisins par le biais d'un couplage résiduel qui peut modifier notamment la direction de mesure de ceux-ci.

### EXPOSÉ DE L'INVENTION

On cherche d'une manière générale à disposer d'un magnétomètre disposant d'une configuration optique la plus simple possible tout en offrant un rapport signal-à-bruit le plus important possible. C'est notamment le cas dans des applications du magnétomètre où la mesure de champ magnétique sert à déduire la position de sources de champ (courants ou matériaux magnétiques) et où un rapport signal à bruit trop faible est susceptible d'induire de fortes incertitudes sur les grandeurs de ces sources ou leur localisation.

A cet effet, l'invention propose un magnétomètre comprenant une cellule destinée à être remplie d'un gaz atomique, une source optique et un détecteur. La source optique est configurée pour éclairer la cellule avec une lumière présentant:
- une contribution de pompe, qui est polarisée linéairement au moins partiellement et sous l'effet de laquelle les atomes du gaz atomique subissent une transition atomique,
- une contribution de sonde, qui est polarisée linéairement et qui subit des variations de polarisation lors de la traversée de la cellule,
- les directions de polarisation de la contribution de pompe et de la contribution de sonde étant colinéaires ou orthogonales.

Le détecteur comprend un analyseur de polarisation configuré pour réaliser une mesure différentielle de la polarisation circulaire droite et de la polarisation circulaire gauche de la contribution de sonde ayant traversée la cellule.

Certains aspects préférés mais non limitatifs de ce magnétomètre sont les suivants :
- la source optique est configurée pour émettre en direction de la cellule un faisceau de pompe formant la contribution de pompe et un faisceau de sonde formant la contribution de sonde ;
- les directions de propagation des faisceaux de pompe et de sonde sont colinéaires ;
- les faisceaux de pompe et de sonde présentent une zone de recouvrement au niveau de la cellule ;
- le faisceau de pompe est accordé en longueur d'onde au centre d'une première raie atomique et le faisceau de sonde est accordé en longueur d'onde de manière à être décalé du centre d'une deuxième raie atomique différente de la première raie atomique en étant par exemple accordé au maximum de la partie imaginaire du profil de Voigt de la deuxième raie atomique ;
- il comprend en outre un élément optique de filtrage spectral du faisceau de pompe ayant traversé la cellule interposé entre la cellule et le détecteur;
- le faisceau de pompe est accordé en longueur d'onde au centre d'une première raie atomique et le faisceau de sonde est accordé en longueur d'onde de manière à être décalé du centre de la première raie atomique en étant par exemple accordé en longueur d'onde au maximum de la partie imaginaire du profil de Voigt de la première raie atomique ;
- la source optique est configurée pour émettre en direction de la cellule un faisceau accordé en longueur d'onde entre le centre d'une première raie atomique et le maximum de la partie imaginaire du profil de Voigt de la première raie atomique ;
- l'analyseur de polarisation est configuré pour réaliser une séparation temporelle des polarisations circulaires droite et gauche de la contribution de sonde ayant traversée la cellule ;
- l'analyseur de polarisation est configuré pour réaliser une séparation spatiale des polarisations circulaires droite et gauche de la contribution de sonde ayant traversée la cellule ;
- l'analyseur de polarisation comprend une lame quart d'onde, un séparateur de polarisations apte à séparer sur un premier et un deuxième chemin la polarisation circulaire droite et la polarisation circulaire gauche de la contribution de sonde ayant traversée la cellule et un photodétecteur sur chacun des premier et deuxième chemins ;
- il comprend en outre un modulateur de la contribution de sonde.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est un schéma d'un magnétomètre conforme à l'invention ;
- la figure 2 représente le profil de Voigt d'une raie de transition atomique de l'hélium-4 ;
- la figure 3 représente la courbe issue de la mesure différentielle réalisée dans l'invention.

### EXPOSÉ DÉTAILLÉ DE MODES DE RÉALISATION PARTICULIERS

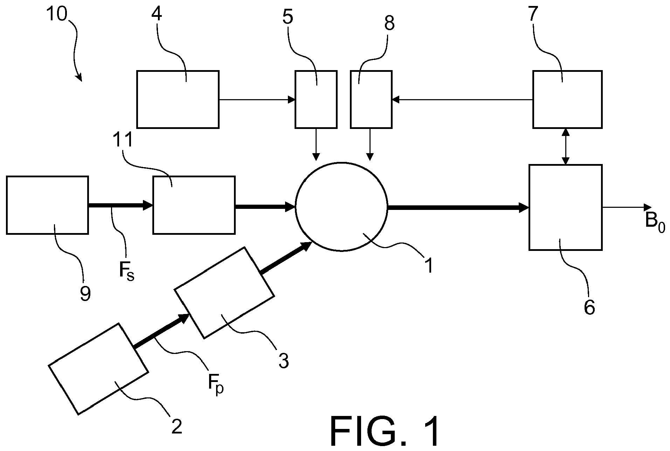

En référence à la figure 1, l'invention porte sur un magnétomètre vectoriel à pompage optique 10 qui comprend une cellule 1 remplie d'un gaz atomique apte à être polarisé en alignement, par exemple de l'hélium-4 ou un gaz alcalin, et qui est soumis à un champ magnétique ambiant Bo. Le magnétomètre 10 comprend par ailleurs une source optique 2, 3, 9, 11 configurée pour éclairer la cellule et un détecteur 6 qui reçoit une lumière ayant traversée la cellule et délivre un signal porteur d'une information relative à l'état d'alignement des atomes du gaz atomique dans la cellule à une électronique de traitement qui exploite ce signal pour fournir une mesure du champ ambiant B₀.

Dans le cas où l'élément sensible est l'hélium-4, le magnétomètre 10 comporte par ailleurs un système de décharge haute fréquence (HF), comprenant un générateur HF 4 et des bobines de surtension 5, pour amener les atomes du gaz atomique dans un état énergisé où ils sont aptes à subir une transition atomique, typiquement dans l'état métastable 2³S₁.

Le magnétomètre peut également comprendre un système d'asservissement en boucle fermé du magnétomètre pour venir constamment soumettre la cellule à un champ magnétique total nul. Le système d'asservissement comprend un régulateur 7 couplé à l'électronique de traitement qui injecte un courant dans des bobines de Helmholtz 8 d'axes orthogonaux qui entourent la cellule 1 afin de générer un champ magnétique de compensation Bc tel que la somme Bc+B₀ est maintenue à zéro en permanence. Alternativement, le magnétomètre peut être opéré en boucle ouverte, sans compensation du champ ambiant.

Dans le cadre de l'invention, la source optique est configurée pour éclairer la cellule avec une lumière présentant à la fois une contribution de pompe et une contribution de sonde, ces deux contributions présentant une polarisation linéaire et des directions de polarisation colinéaires ou orthogonales.

Sous l'effet de la contribution de pompe, les atomes du gaz atomique subissent une transition atomique. La contribution de pompe peut à cet effet être accordée en longueur d'onde au centre d'une raie de transition atomique, par exemple sur la raie D₀ à 1083 nm dans le cas de l'hélium-4, voire être légèrement décalée d'un tel centre comme cela sera décrit par la suite pour assurer à la fois un rôle de pompe et un rôle de sonde. Par longueur d'onde accordée au centre d'une raie, on entend typiquement que la longueur d'onde est écartée du centre de la raie d'au plus la moitié de la largeur à mi-hauteur de la raie, soit à ± 0,85 Ghz du centre pour la raie D₀ de l'hélium.

La contribution de sonde subit quant à elle des variations de polarisation lors de la traversée de la cellule. Elle peut à cet effet être accordée en longueur d'onde au maximum de la partie imaginaire du profil de Voigt d'une raie de transition atomique (qui peut ou non être la même que celle utilisée pour le pompage) ou être suffisamment éloignée du centre de la raie atomique pour ne pas pomper également les atomes, en étant pour cela typiquement écartée du centre de la raie d'au moins un quart de la largeur à mi-hauteur de la raie.

Lorsque la raie utilisée pour le sondage est différente de celle utilisée pour le pompage, les contributions de sonde et de pompe sont alors accordées sur deux longueurs d'ondes relativement éloignées. Dans un tel cas de figure, un élément optique de filtrage spectral de la lumière peut être interposé entre la cellule et le détecteur afin de supprimer la contribution de pompe pour qu'elle n'apporte pas de bruit sur la détection.

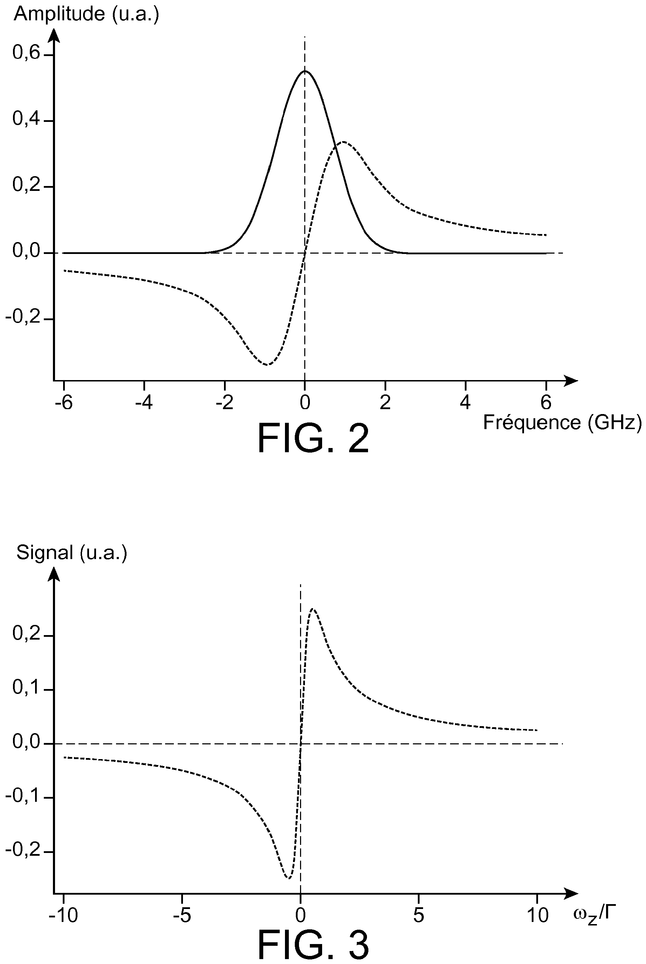

On a représenté sur la figure 2, le profil de Voigt de la raie de transition atomique D₀ de l'hélium-4 et plus particulièrement la partie réelle de ce profil en trait plein et la partie imaginaire de ce profil en trait pointillé. La partie réelle est représentative de l'intensité du pompage tandis que la partie imaginaire est représentative de l'intensité du signal de sonde. Sur cette figure, la raie est centrée sur la fréquence zéro et le maximum de la partie imaginaire est à 943,5 MHz du centre de la raie.

Dans un mode de réalisation possible, qui est celui représenté sur la figure 1, la source optique est configurée pour émettre en direction de la cellule un faisceau de pompe Fp formant la contribution de pompe et un faisceau de sonde Fs formant la contribution de sonde. La cellule est ainsi éclairée par une source optique qui comprend un élément de pompage 2 apte à émettre en direction de la cellule 1 le faisceau de pompe Fp et un élément de sondage 9 apte à émettre en direction de la cellule 1 le faisceau de sonde Fs. Ces éléments 2, 9 peuvent être des lasers, par exemple des diodes semi-conductrices.

Le faisceau de pompe Fp est polarisé au moyen d'un dispositif de polarisation 3 intercalé entre l'élément de pompage 2 et la cellule 1 ou directement intégré à l'élément de pompage 2. Dans le cadre de l'invention, le faisceau de pompe Fp est polarisé linéairement, au moins partiellement, ce qui induit des états atomiques dits « alignés » dans la cellule 1, l'axe d'alignement étant fixé par la direction du champ électrique de la lumière utilisée pour le pompage. Dans ce qui suit, on considère un trièdre de référence xyz avec l'axe x aligné sur la direction de polarisation linéaire du faisceau de pompe. Par faisceau partiellement polarisé, on entend un faisceau qui est partie polarisé linéairement selon l'axe x et en partie dépolarisé, ses paramètres de Stokes étant alors tels que S1+S2+S3 ≤ S0 comme cela est présenté dans le chapitre 8 du livre « Optics » de Eugene Hecht, Addison Wesley 2002.

Le faisceau de sonde Fs est polarisé linéairement au moyen d'un dispositif de polarisation 11 intercalé entre l'élément de sondage 9 et la cellule 1 ou directement intégré à l'élément de sondage 9. Sa direction de polarisation est selon l'axe x (colinéaire à la direction de polarisation du faisceau de pompe) ou selon l'axe y (orthogonale à la direction de polarisation du faisceau de pompe). Le faisceau de sonde Fs se propage selon l'axe z du trièdre xyz.

Sur la figure 1, les directions de propagation des faisceaux de pompe et de sonde ne sont pas colinéaires mais ces faisceaux présentent un léger décalage angulaire tel qu'ils présentent une zone de recouvrement au niveau de la cellule. Dans une telle configuration, on prévoit avantageusement que le faisceau de pompe ne soit pas incident sur le détecteur. Le décalage angulaire est par exemple au plus de 4° de sorte que les deux faisceaux viennent en incidence sur la cellule via une même fenêtre optique.

Alternativement, les directions de propagation des faisceaux de pompe et de sonde sont colinéaires de sorte que le magnétomètre ne compte qu'un seul accès optique.

Dans un autre mode de réalisation possible à un seul accès optique, la source optique est configurée pour émettre en direction de la cellule un seul faisceau polarisé linéairement, ce faisceau jouant à la fois le rôle de pompe et de sonde en portant à la fois la contribution de pompe et la contribution de sonde. Pour ce faire, ce faisceau est accordé en longueur d'onde entre le centre d'une raie atomique et le maximum de la partie imaginaire du profil de Voigt de la raie atomique pour réaliser un compromis adéquat entre efficacité du rôle de pompe et efficacité du rôle de sonde, en étant par exemple à 563.9 MHz du centre de la raie D₀ pour l'hélium 4.

Selon l'invention, le détecteur 6 comprend un analyseur de polarisation configuré pour réaliser une mesure différentielle de la polarisation circulaire droite σ+ et de la polarisation circulaire gauche σ- de la contribution de sonde ayant traversée la cellule. Le détecteur 6 vient ainsi délivrer, en tant que signal porteur d'une information relative à l'état d'alignement des atomes du gaz atomique dans la cellule, un signal représentatif de la différence des intensités des polarisations circulaires droite et gauche. Ce signal dépend uniquement de la composante du champ magnétique selon l'axe z et présente, comme représenté sur la figure 3, la forme d'une courbe lorentzienne dispersive centrée en champ nul. Sur cette figure 3, ω_{z}/Γ correspond à la pulsation de Larmor du champ magnétique selon l'axe z mesuré, divisé par le terme de relaxation du système.

L'analyseur de polarisation peut être configuré pour réaliser une séparation temporelle des polarisations circulaires droite et gauche de la contribution de sonde ayant traversée la cellule, par exemple à l'aide d'un modulateur photoélastique. Un photodétecteur vient ainsi détecter alternativement dans le temps chacune de ces polarisations.

Alternativement, l'analyseur de polarisation peut être configuré pour réaliser une séparation spatiale des polarisations circulaires droite et gauche de la contribution de sonde ayant traversée la cellule. A cet effet, l'analyseur de polarisation peut comprendre une lame quart d'onde, un séparateur de polarisations apte à séparer sur un premier et un deuxième chemin la polarisation circulaire droite et la polarisation circulaire gauche de la contribution de sonde ayant traversée la cellule et un photodétecteur sur chacun des premier et deuxième chemins.

Le magnétomètre selon l'invention peut par ailleurs comprendre un modulateur de la contribution de sonde. La contribution de sonde peut ainsi être modulée en amplitude, en polarisation, voire en longueur d'onde dans un mode dégradé d'implémentation d'une modulation d'amplitude. La fréquence de modulation peut être suffisamment élevée, par exemple de l'ordre de 30 kHz, pour s'affranchir des problématiques de bruit basse fréquence du laser fournissant la contribution de sonde, sans pour autant perdre en amplitude de signal. Le modulateur de la contribution de sonde peut également être un modulateur de polarisation, par exemple un modulateur photo-acoustique, agencé entre la cellule de mesure et le détecteur.

L'invention permet de fournir un magnétomètre permettant la mesure d'une composante du champ magnétique ambiant qui dispose d'un accès optique simplifié (une seule fenêtre) et ne présente pas la perte de signal-à-bruit propre aux magnétomètres à résonance paramétrique. La contribution de pompe, qui est polarisée linéairement et ne subit aucune modification de polarisation, est invisible sur le signal issu de la mesure différentielle.

Le principe de fonctionnement décrit précédemment pour la mesure du champ selon l'axe z peut être élargi à la mesure de plusieurs composantes du champ magnétique (i.e. mesure selon plusieurs axes) avec une composante mesurée fixée par la direction de propagation d'une contribution de sonde dédiée. Dans ce qui suit, on conserve la configuration décrite précédemment, pompant suivant l'axe x et mesurant suivant l'axe z.

Si on veut mesurer l'axe y en plus de l'axe z, on rajoute une contribution de sonde polarisée linéairement suivant l'axe x ou l'axe y et qui se propage selon l'axe y.

Si on veut mesurer l'axe x en plus de l'axe z, on rajoute une contribution de sonde qui se propage selon l'axe x. Il est alors nécessaire d'ajouter une composante de pompage du système suivant un axe différent, soit en utilisant une seule contribution de pompe partiellement polarisée, soit en ayant recours à une nouvelle contribution de pompe.

Si on veut réaliser une mesure suivant les trois axes, il faut disposer de trois contributions de sonde se propageant chacune dans une direction de l'espace différente (x, y et z), et d'un pompage optique présentant des composantes suivant deux axes différents a minima. Une façon simple consiste à utiliser trois faisceaux au total, où chaque faisceau réalise à la fois un rôle de pompe et de sonde, et dont deux d'entre eux partagent le même axe de polarisation.

L'invention porte également sur un procédé de mesure d'un champ magnétique à l'aide du magnétomètre tel que précédemment décrit. Ce procédé comprend notamment :
- l'éclairage, par la source optique, de la cellule avec une lumière présentant :
   ∘ une contribution de pompe, qui est polarisée linéairement au moins partiellement et sous l'effet de laquelle les atomes du gaz atomique subissent une transition atomique,
   ∘ une contribution de sonde, qui est polarisée linéairement et qui subit des variations de polarisation lors de la traversée de la cellule,
   ∘ les directions de polarisation de la contribution de pompe et de la contribution de sonde étant colinéaires ou orthogonales; et
- la réalisation au moyen du détecteur d'une mesure différentielle de la polarisation circulaire droite et de la polarisation circulaire gauche de la contribution de sonde ayant traversée la cellule.

## Revendications

1. Magnétomètre (10) comprenant une cellule (1) destinée à être remplie d'un gaz atomique, une source optique (2, 3, 9, 11) et un détecteur (6), **caractérisé en ce que** la source optique est configurée pour éclairer la cellule avec une lumière présentant:
- une contribution de pompe (Fp), qui est polarisée linéairement au moins partiellement et sous l'effet de laquelle les atomes du gaz atomique subissent une transition atomique,
- une contribution de sonde (Fs), qui est polarisée linéairement et qui subit des variations de polarisation lors de la traversée de la cellule,
- les directions de polarisation de la contribution de pompe et de la contribution de sonde étant colinéaires ou orthogonales,
et **en ce que** le détecteur (6) comprend un analyseur de polarisation configuré pour réaliser une mesure différentielle de la polarisation circulaire droite et de la polarisation circulaire gauche de la contribution de sonde ayant traversée la cellule.

2. Magnétomètre selon la revendication 1, dans lequel la source optique est configurée pour émettre en direction de la cellule un faisceau de pompe formant la contribution de pompe (Fp) et un faisceau de sonde (Fs) formant la contribution de sonde.

3. Magnétomètre selon la revendication 2, dans lequel les directions de propagation des faisceaux de pompe et de sonde sont colinéaires.

4. Magnétomètre selon la revendication 2, dans lequel les faisceaux de pompe et de sonde présentent une zone de recouvrement au niveau de la cellule.

5. Magnétomètre selon l'une des revendications 2 à 4, dans lequel le faisceau de pompe est accordé en longueur d'onde au centre d'une première raie atomique et le faisceau de sonde est accordé en longueur d'onde de manière à être décalé du centre d'une deuxième raie atomique différente de la première raie atomique en étant par exemple accordé au maximum de la partie imaginaire du profil de Voigt de la deuxième raie atomique.

6. Magnétomètre selon la revendication 5, comprenant en outre un élément optique de filtrage spectral du faisceau de pompe ayant traversé la cellule interposé entre la cellule et le détecteur.

7. Magnétomètre selon l'une des revendications 2 à 4, dans lequel le faisceau de pompe est accordé en longueur d'onde au centre d'une première raie atomique et le faisceau de sonde est accordé en longueur d'onde de manière à être décalé du centre de la première raie atomique en étant par exemple accordé en longueur d'onde au maximum de la partie imaginaire du profil de Voigt de la première raie atomique.

8. Magnétomètre selon la revendication 1, dans lequel la source optique est configurée pour émettre en direction de la cellule un faisceau accordé en longueur d'onde entre le centre d'une première raie atomique et le maximum de la partie imaginaire du profil de Voigt de la première raie atomique.

9. Magnétomètre selon l'une des revendications 1 à 8, dans lequel l'analyseur de polarisation est configuré pour réaliser une séparation temporelle des polarisations circulaires droite et gauche de la contribution de sonde ayant traversée la cellule.

10. Magnétomètre selon l'une des revendications 1 à 8, dans lequel l'analyseur de polarisation est configuré pour réaliser une séparation spatiale des polarisations circulaires droite et gauche de la contribution de sonde ayant traversée la cellule.

11. Magnétomètre selon la revendication 10, dans lequel l'analyseur de polarisation comprend une lame quart d'onde, un séparateur de polarisations apte à séparer sur un premier et un deuxième chemin la polarisation circulaire droite et la polarisation circulaire gauche de la contribution de sonde ayant traversée la cellule et un photodétecteur sur chacun des premier et deuxième chemins.

12. Magnétomètre selon l'une des revendications 1 à 11, comprenant en outre un modulateur de la contribution de sonde.

13. Procédé de mesure d'un champ magnétique à l'aide d'un magnétomètre vectoriel (10) comprenant une cellule (1) remplie d'un gaz atomique, une source optique (2 , 3, 9, 11) et un détecteur (6), le procédé comprenant :
- l'éclairage, par la source optique, de la cellule avec une lumière présentant :
∘ une contribution de pompe (Fp), qui est polarisée linéairement au moins partiellement et sous l'effet de laquelle les atomes du gaz atomique subissent une transition atomique,
∘ une contribution de sonde (Fs), qui est polarisée linéairement et qui subit des variations de polarisation lors de la traversée de la cellule,
∘ les directions de polarisation de la contribution de pompe et de la contribution de sonde étant colinéaires ou orthogonales ; et
- la réalisation au moyen du détecteur (6) d'une mesure différentielle de la polarisation circulaire droite et de la polarisation circulaire gauche de la contribution de sonde ayant traversée la cellule.
